Europäisches Patentamt

European Patent Office

Office européen des brevets

(19)

(11) **EP 1 405 480 B1**

(12) **EUROPÄISCHE PATENTSCHRIFT**

(45) Veröffentlichungstag und Bekanntmachung des Hinweises auf die Patenterteilung:
**27.04.2005 Patentblatt 2005/17**

(51) Int Cl.$^7$: **H04L 27/36**, H03F 1/32

(21) Anmeldenummer: 02762342.0

(86) Internationale Anmeldenummer:
**PCT/EP2002/007707**

(22) Anmeldetag: **10.07.2002**

(87) Internationale Veröffentlichungsnummer:
**WO 2003/007568 (23.01.2003 Gazette 2003/04)**

(54) **VORVERZERRUNGSLINEARISIERUNGS-VORRICHTUNG UND -VERFAHREN**

PREDISTORTION LINEARIZATION DEVICE AND METHOD

DISPOSITIF ET PROCEDE DE LINEARISATION PAR PREDISTORSION

(84) Benannte Vertragsstaaten:
**AT BE BG CH CY CZ DE DK EE ES FI FR GB GR IE IT LI LU MC NL PT SE SK TR**

(30) Priorität: **10.07.2001 DE 10133332**

(43) Veröffentlichungstag der Anmeldung:
**07.04.2004 Patentblatt 2004/15**

(73) Patentinhaber: **Fraunhofer-Gesellschaft zur Förderung der angewandten Forschung e.V. 80636 München (DE)**

(72) Erfinder:
• **PERTHOLD, Rainer**
  **91085 Weisendorf (DE)**
• **GERHÄUSER, Heinz**
  **91344 Waischenfeld (DE)**

(74) Vertreter: **Stöckeler, Ferdinand, Dipl.-Ing. Schoppe, Zimmermann, Stöckeler & Zinkler Postfach 246 82043 Pullach bei München (DE)**

(56) Entgegenhaltungen:
**WO-A-01/08319          DE-A- 19 631 388**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**EP 1 405 480 B1**

**Beschreibung**

Die vorliegende Erfindung bezieht sich auf Vorrichtungen und Verfahren zum Vorverzerren von über nichtlineare Übertragungsstrecken, insbesondere Leistungsverstärker, zu übertragenden Signalen, um durch die nichtlineare Übertragungsstrecke verursachte Nichtlinearitäten zu kompensieren.

Nach dem Stand der Technik ist eine Vielzahl von Linearisierungseinrichtungen bekannt. Rein digitale Linearisierungseinrichtungen, bei denen eine Vorverzerrung, um eine entsprechende Nichtlinearität eines HF-Leistungsverstärkers zu kompensieren, im Basisbandbereich durchgeführt wird, sind beispielsweise in der US-5,049,832 und der US-5,898,338 beschrieben. Die Verwendung solcher rein digitaler Linearisierungseinrichtungen ist auf Fälle beschränkt, in denen das Nutzsignal eine Bandbreite von typischerweise 10 MHz nicht übersteigt. Ein Nutzsignal von 10 MHz hat eine entsprechende Bandbreite des vorverzerrten Signals von typischerweise 30 bis 50 MHz zur Folge. Hier stößt man an die Grenzen der Realisierbarkeit von Digital/Analog-Wandlern hinsichtlich Stromverbrauch, Komplexität der Interpolation und Bandbreite der Digital/Analog-Wandler. Darüber hinaus muß die Abtastrate der digitalen Versarbeitung entsprechend hoch gewählt sein, um diese Bandbreitenerhöhung ohne Überfaltungen verarbeiten zu können.

Die oben angegebene Bandbreite von 30 bis 50 MHz lässt sich mit den heutigen verfügbaren Digital/Analog-Wandlern nicht oder nur sehr schwer mit der erforderlichen Qualität, beispielsweise bezüglich des Frequenzgangs, direkt auf der Zwischenfrequenz ausgeben.

Neben den oben beschriebenen rein digitalen Vorverzerrungen existieren Linearisierungseinrichtungen, bei denen eine Vorverzerrung vollständig im analogen HF-Bereich durchgeführt wird, wobei derartige Techniken beispielsweise in der DE 19631388 A1 oder der DE 19927952 A1 beschrieben sind. Derartige analoge Vorverzerrungseinrichtungen zeichnen sich allesamt durch eine schlechte Beeinflussbarkeit der Linearisierungsfunktion aus.

Aus der WO-A-0108319 mit zugehöriger EP-A-1199814 ist eine Verzerrungskompensation bekannt, bei der digital ein Fehlersignal aus einem digitalen, mittels eines Verstärkers zu verstärkenden Eingangssignal und einem einer Analog/Digital-Wandlung unterzogenen Ausgangssignal des Verstärkers gewonnen wird. Das Eingangssignal und das Ausgangssignal werden separat voneinander einer Digital/Analog-Wandlung unterzogen, woraufhin dieselben unter Verwendung eines Kombinierers einer Vektor-Addition unterzogen werden. Das addierte Signal wird dem Verstärker zugeführt.

Die Aufgabe der vorliegenden Erfindung besteht darin, eine Vorverzerrungslinearisierungsvorrichtung bzw. ein Vorverzerrungslinearisierungsverfahren zu schaffen, die die Linearisierung sehr breitbandiger Signale bei gleichzeitiger guter Beeinflussbarkeit der verwendeten Linearisierungsfunktion ermöglichen.

Diese Aufgabe wird durch Vorrichtungen nach Anspruch 1 oder 10 und Verfahren nach Anspruch 7 oder 11 gelöst.

Erfindungsgemäß erfolgt somit die Ermittlung der komplexen Korrekturwerte, die zur Vorverzerrung eines zu übertragenden Signals verwendet werden, vollständig digital. Die eigentliche Vorverzerrung, d.h. die Beaufschlagung des zu übertragenden Signals mit den Korrekturwerten erfolgt danach analog. Dadurch erreicht man, dass die Bandbreitenerweiterung, beispielsweise von 10 MHz auf 30 - 50 MHz, wie sie oben beschrieben ist, erst im analogen Bereich erfolgt. Die digitale Signalverarbeitung kann somit mit einer niedrigeren Taktrate arbeiten.

Die Korrekturwerte sind bei bevorzugten Ausführungsbeispielen der Erfindung komplexe Korrekturwerte, wobei durch die nichtlineare Übertragungsstrecke erzeugte Nichtlinearitäten nach Betrag und Phase weitgehend kompensiert werden.

Bei bevorzugten Ausführungsbeispielen wird vor dem Vorverzerren des analogen zu übertragenden Signals dasselbe in den Zwischenfrequenzbereich oder Hochfrequenzbereich hochgemischt. Somit können Probleme hinsichtlich einer begrenzten Qualität eines zur Beaufschlagung des zu übertragenden Signals mit den Korrekturwerten verwendeten Vektormodulators hinsichtlich Lokaloszillator-Leakage oder hinsichtlich einer Imbalance vermieden werden, die auftreten können, wenn das zu übertragende Signal nicht auf einer Zwischenfrequenz, sondern im Basisband über zwei Digital/Analog-Wandler mit nachgeschaltetem analogen Vektormodulator ausgegeben wird. Darüber hinaus sind komplexe analoge Multiplizierer, die die Beaufschlagung des analogen zu übertragenden Signals mit den Korrekturwerten mit einer erforderlichen Genauigkeit durchführen können, besser zu realisieren, wenn die Bandbreite des Signals klein zur Trägerfrequenz desselben ist, so dass diese komplexe Multiplikation vorzugsweise nach einem Hochmischen des zu übertragenden Signals in einen Zwischenfrequenzbereich oder noch vorzugsweiser in einen Hochfrequenzbereich durchgeführt wird.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:

Fig. 1     eine schematische Darstellung eines bevorzugten Ausführungsbeispiels einer erfindungsgemäßen Vorverzerrungslinearisierungsvorrichtung; und

Fig. 2     eine schematische Darstellung eines erfindungsgemäß verwendbaren komplexen Multiplizierers.

Im folgenden wird die vorliegende Erfindung anhand einer Vorverzerrungslinearisierungsvorrichtung für einen Leistungsverstärker beschrieben, wobei jedoch klar ist, dass die vorliegende Erfindung auch auf andere nichtlineare Übertragungsstrecken anwendbar ist.

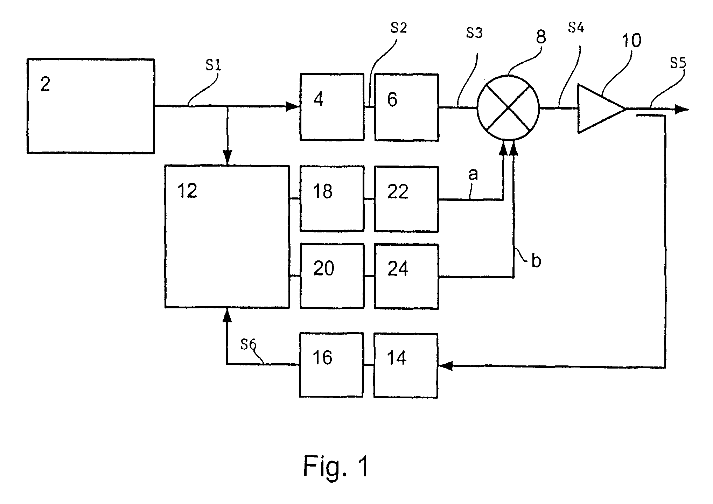

Bei dem in Fig. 1 gezeigten Ausführungsbeispiel der erfindungsgemäßen Vorverzerrungslinearisierungsvorrichtung wird ein digitales Basisbandsignal S1 als Eingangssignal durch eine Signalquelle 2 geliefert. Die Signalquelle 2 kann ein beliebiger Modulator, beispielsweise ein OFDM-Modulator, ein QPSK-Modulator oder ein CDMA-Modulator, aber auch ein Analog/Digital-Umsetzer, der ein analoges, moduliertes Signal in ein digitales Signal umsetzt, sein.

Das digitale zu übertragende Basisbandsignal wird einem Digital/Analog-Wandler 4 zugeführt, der ein Signal S2 ausgibt, das eine analoge Version des zu übertragenden Signals darstellt. Der Digital/Analog-Wandler 4 kann dabei neben dem Umsetzen des analogen Signals in ein digitales Signal ein Aufwärtsmischen des Signals S1 in den Zwischenfrequenzbereich bewirken, so dass das Signal S2 eine analoge Version des zu übertragenden Signals im Zwischenfrequenzbereich darstellt. Bei dem gezeigten Ausführungsbeispiel wird dieses Signal S2 einem Aufwärtsmischer 6 zugeführt, der das Signal S2 in den Hochfrequenzbereich hochmischt, wobei das hochgemischte Signal in Fig. 1 mit S3 bezeichnet ist. Bei dem gezeigten Ausführungsbeispiel wird dieses Signal S3 nachfolgend in einem Vorverzerrer 8, der bei bevorzugten Ausführungsbeispielen der vorliegenden Erfindung durch einen komplexen Multiplizierer gebildet ist, mit Korrekturwerten beaufschlagt, wodurch ein vorverzerrtes Signal S4 erzeugt wird. Dieses vorverzerrte Signal S4 wird dann dem Leistungsverstärker 10 zugeführt.

Die verwendeten Korrekturkoeffizienten werden unter Verwendung einer Korrekturwertermittlungseinrichtung 12 ermittelt. In der Korrekturwertermittlungseinrichtung 12 ist beispielsweise eine Tabelle gespeichert, in der jeweiligen Eingangssignalen zugeordnete komplexe Korrekturwerte gespeichert sind. Der Aufbau einer solchen Korrekturwertermittlungseinrichtung ist Fachleuten bekannt, wobei diesbezüglich beispielsweise auf die in der Beschreibungseinleitung genannten Schriften zum Stand der Technik verwiesen wird.

An dieser Stelle sei lediglich angemerkt, dass vorzugsweise ein jeweiliger komplexer Korrekturkoeffizient einem Leistungsbereich des Eingangssignals S1 zugeordnet ist, wobei die Korrekturwertermittlungseinrichtung 12 eine Einrichtung zum Bestimmen eines Maßes für die Leistung des Eingangssignals S1 aufweist, wobei auf der Grundlage dieses Maßes dann auf die Tabelle der Korrekturwertermittlungseinrichtung zugegriffen wird. Das Maß für die Leistung des Eingangssignals kann beispielsweise durch eine Betragsquadratbildungseinrichtung implementiert sein. Alternativ kann eine Einrichtung zum Abschätzen der Leistung basierend auf der Amplitude des Eingangssignals vorgesehen sein.

Es sei jedoch angemerkt, dass erfindungsgemäß jegliche Linearisierungsfunktion in der Korrekturwertermittlungseinrichtung 12 implementiert sein kann, die Korrekturwerte, vorzugsweise komplexe Korrekturwerte, liefert, die zur Vorverzerrung des zu übertragenden Signals verwendet werden können, um durch die nichtlineare Übertragungsstrecke, in diesem Fall den Leistungsverstärker 10, eingeführte Nichtlinearitäten im wesentlichen zu kompensieren. Die Korrekturfunktion kann dabei sowohl in karthesischen, als auch in polaren oder in nicht-orthogonalen Koordinaten implementiert sein.

Ferner kann vorzugsweise eine Adaptionseinrichtung vorgesehen sein, durch die die in der Korrekturwertermittlungseinrichtung definierte Linearisierungsfunktion stetig oder zu bestimmten Zeitpunkten aktualisiert wird. Zu diesem Zweck wird bei dem bevorzugten Ausführungsbeispiel das Ausgangssignal S5 des Leistungsverstärkers 10 abgegriffen, einer Abwärtsmischung in einem Abwärtsmischer 14 unterzogen und nachfolgend einem Analog/Digital-Wandler 16 zugeführt. Am Ausgang des Analog/Digital-Wandlers 16 liegt eine in das Basisband heruntergemischte digitale Version S6 des Ausgangssignals S5 des Leistungsverstärkers vor. Dieses Signal S6 wird mit dem zugeordneten Eingangssignal S1 verglichen, um so die komplexen Korrekturkoeffizienten für die Korrekturwertermittlungseinrichtung zu erzeugen bzw. zu aktualisieren. Der hierzu erforderliche Schaltungsaufbau kann derliche Schaltungsaufbau kann in die Korrekturwertermittlungseinrichtung integriert sein.

Bei dem in Fig. 1 dargestellten Ausführungsbeispiel besteht jeder Korrekturwert aus einem Amplitudenkorrekturkorrekturkoeffizienten und einem Phasenkorrekturkorrekturkoeffizienten. Diese Korrekturkoeffizienten werden jeweiligen Digital/Analog-Wandlern 18 und 20 zugeführt, in denen eine analoge Version a bzw. b der Korrekturkoeffizienten erzeugt wird. Bei dem dargestellten Ausführungsbeispiel werden die Korrekturkoeffizienten nach der Digital/Analog-Wandlung derselben einer Tiefpassfilterung in entsprechenden Tiefpaßfiltern 22, 24 unterzogen.

Die analogen Korrekturkoeffizienten werden dann dem Vorverzerrer 8 in Form des komplexen Multiplizierers zugeführt, der analog realisiert ist. Der Vorverzerrer 8 verändert die Amplitude und die Phase des Signals S3 in Abhängigkeit von den analogen Korrekturkoeffizienten a und b derart, dass durch den Leistungsverstärker bei der nachfolgenden Übertragung eingeführte Nichtlinearitäten nach Betrag und Phase weitgehend kompensiert werden.

Durch den oben beschriebenen Schaltungsaufbau erfolgt erfindungsgemäß die Ermittlung der Korrekturwerte vollständig digital, während das Durchführen der eigentlichen Vorverzerrung, d.h. das Beaufschlagen des Signals mit den Vorverzerrungskoeffizienten analog erfolgt.

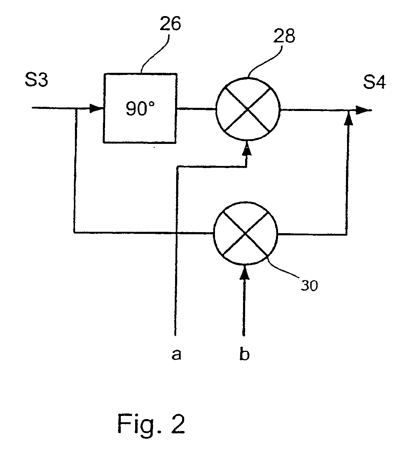

Ein Beispiel für eine konkrete Realisierung des Vorverzerrers 8 als komplexer Multiplizierer ist in Fig. 2 gezeigt. Bei diesem komplexen Multiplizierer wird ein Teil des Eingangssignals S3 einem 90°-Phasenschieber 26 zugeführt. Der um 90° verschobene Signalanteil wird dann in einem Multiplizierer 28 mit dem Korrekturkoeffizienten a multipliziert. Ferner wird bei dem in Fig. 2 gezeigten Multiplizierer das Eingangssignal S3 in einem Multiplizierer 30 direkt mit dem Korrekturkoeffizienten b multipliziert. Die durch die beiden Multiplikationen erhaltenen Signale werden dann kombiniert, um das vorverzerrte Signal S4 zu erzeugen.

Der oben beschriebene Aufbau eines Multiplizierers ist dann vorteilhaft einsetzbar, wenn die Bandbreite des Signals S3 sehr klein zur Trägerfrequenz desselben ist, da ansonsten die Phasenverschiebung von 90° in dem Phasenschieber 26 nicht mehr mit der erforderlichen Genauigkeit realisiert werden kann. Daher ist der gezeigte komplexe Multiplizierer vorteilhaft einsetzbar, wenn das Signal S3 die in den Hochfrequenzbereich umgesetzte Version des analogen Eingangssignals darstellt.

Alternativ zu der oben beschriebenen Vorgehensweise kann die komplexe Multiplikation zur Kompensation des Amplitudenfehlers und Phasenfehlers des Verstärkers im analogen Bereich erfolgen, indem eine Frequenzumsetzung, beispielsweise vom Zwischenfrequenzbereich in den Hochfrequenzbereich, gemäß folgender Gleichung ausgenutzt wird:

$$y(t) = a(t) \cdot (y(t) \cdot \cos(wt)) + b(t) \cdot (y(t) \cdot \sin(wt)).$$

Dabei sind a(t) und b(t) die aus der Linearisierungsfunktion ermittelten Korrekturkoeffizienten. In aller Regel kann man die Linearisierungsfunktion so wählen, dass sich a(t) und b(t) auf positive Werte beschränken, so dass zur Multiplikation auch einfache Dämpfungsglieder herangezogen werden können.

Die vorliegende Erfindung schafft somit eine Linearisierungsvorrichtung und ein Linearisierungsverfahren, bei denen die Korrekturwerte vollständig digital ermittelt werden, die eigentliche Korrektur jedoch im Analogen vorgenommen wird, wobei die Korrektur dabei sowohl in karthesischen, als auch in polaren oder in nicht-orthogonalen Koordinaten erfolgen kann.

Die vorliegende Erfindung kann insbesondere Anwendung bei Repeatern für den Mobilfunk finden, bei denen die Nichtlinearität des Endverstärkers zu nichttolerierbaren Nebenaussendungen führen würde. Darüber hinaus ist die Erfindung speziell dann gut zu verwenden, wenn die Bandbreite des Nutzsignals, und damit entsprechend die Bandbreite des vorverzerrten Signals so hoch ist, dass sie nur mehr schwer über einen Digital/Analog-Wandler direkt im Zwischenfrequenzbereich ausgegeben werden kann.

**Patentansprüche**

1. Vorrichtung zur Vorverzerrungslinearisierung eines über eine nichtlineare Übertragungsstrecke (10) zu übertragenden Signals, mit folgenden Merkmalen:

   einer Signalquelle (2) zum Bereitstellen einer digitalen Basisbandversion (S1) des zu übertragenden Signals;

   einer Einrichtung (12) zur Ermittlung digitaler Korrekturwerte für das zu übertragende Signal, die mit dem Ausgang der Signalquelle verbunden ist und die unter Verwendung der digitalen Basisbandversion des zu übertragenden Signals als Eingangssignal auf eine Tabelle zugreift, in der jeweiligen Eingangssignalen zugeordnete komplexe Korrekturwerte abgelegt sind, wobei die komplexen Korrekturwerte basierend auf einer vorher erfassten Übertragungsfunktion der nichtlinearen Übertragungsstrecke ermittelt wurden;

   einem Digital/Analog-Wandler (4), der mit dem Ausgang der Signalquelle verbunden ist, zum Erzeugen einer analogen Version (S2) des zu übertragenden Signals aus der digitalen Basisbandversion (S1) desselben;

   einem Digital/Analog-Wandler (18, 20) zum Erzeugen von analogen Korrekturwerten (a, b) aus den digitalen Korrekturwerten; und

   einem Aufwärtsmischer (6) zum Hochmischen des zu übertragenden Signals in einen Zwischenfrequenzbereich oder Hochfrequenzbereich (S3) vor dem Vorverzerren desselben; **gekennzeichnet durch** eine Einrichtung zum analogen Vorverzerren (8) des zu übertragenden Signals **durch** Multiplizieren der hochgemischten Version der analogen Version (S3) des zu übertragenden Signals mit den analogen Korrekturwerten (a, b), um **dadurch durch** die nichtlineare Übertragungsstrecke verursachte Nichtlinearitäten weitgehend zu kompensieren.

2. Vorrichtung nach Anspruch 1, die ferner eine Einrichtung zum Abgreifen eines analogen Ausgangssignals (S5) der nichtlinearen Übertragungsstrecke (10) und einen Abwärtsmischer und einen Analog/Digital-Wandler zum Umsetzen des Ausgangssignals in den Basisbandbereich und zum Erzeugen einer digitalen Version desselben aufweist, wobei ferner eine Einrichtung zum Erzeugen und/oder Aktualisieren der Korrekturwerte basierend auf der digitalen Version des Ausgangssignals (S5) und der digitalen Basisbandversion (S1) des zu übertragenden Signals vorgesehen ist.

3. Vorrichtung nach einem der Ansprüche 1 oder 2, bei der die nichtlineare Übertragungsstrecke (10) ein Leistungsverstärker ist.

4. Vorrichtung nach nach einem der Ansprüche 1 bis 3, bei der die Einrichtung (8) zum Vorverzerren ein komplexer Multiplizierer ist.

5. Vorrichtung nach Anspruch 4, bei der der komplexe Multiplizierer einen ersten Multiplizierer (28), der eine Multiplikation einer um 90° phasenverschobenen Version des Eingangssignals des komplexen Multiplizierers mit einem ersten Koeffizienten (a) durchführt, und einen zweiten Multiplizierer (30), der eine Multiplikation des Eingangssignals des komplexen Multiplizierers mit einem zweiten Koeffizienten (b) durchführt, aufweist, wobei der erste und der zweite Koeffizient zusammen einen komplexen Korrekturwert darstellen.

6. Vorrichtung nach einem der Ansprüche 1 bis 5, die ferner ein Tiefpassfilter (22, 24) zum Tiefpassfiltern der analogen Korrekturwerte aufweist.

7. Verfahren zum Durchführen einer Vorverzerrungslinearisierung eines über eine nichtlineare Übertragungsstrecke (10) zu übertragenden Signals, mit folgenden Schritten:

Bereitstellen einer digitalen Basisbandversion (S1) des zu übertragenden Signals am Ausgang einer Signalquelle;

Empfangen der am Ausgang der Signalquelle bereitgestellten digitalen Basisbandversion des zu übertragenden Signals und Ermitteln digitaler Korrekturwerte für das zu übertragende Signal durch Zugreifen auf eine Tabelle ünter Verwendung der digitalen Basisbandversion des zu übertragenden Signals als Eingangssignal, wobei in der Tabelle jeweiligen Eingangssignalen zugeordnete komplexe Korrekturwerte abgelegt sind, wobei die komplexen Korrekturwerte basierend auf einer vorab erfassten Übertragungscharakteristik der nichtlinearen Übertragungsstrecke (10) ermittelt wurden;

Durchführen einer Digital/Analog-Wandlung der am Ausgang der Signalquelle bereitgestellten, digitalen Basisbandversion (S1) des zu übertragenden Signals zum Erzeugen einer analogen Version (S2) des zu übertragenden Signals;

Durchführen einer Digital/Analog-Wandlung der digitalen Korrekturwerte zum Erzeugen analoger Korrekturwerte (a, b); und

Hochmischen des zu übertragenden Signals in einen Zwischenfrequenzbereich oder Hochfrequenzbereich (S3) vor oder während des Vorverzerrens desselben; **gekennzeichnet durch** den Schritt des

Analogen Vorverzerrens des zu übertragenden Signals **durch** Multiplizieren der hochgemischten Version des zu übertragenden Signals mit den analogen komplexen Korrekturwerten (a, b), um **dadurch durch** die nichtlineare Übertragungsstrecke (10) verursachte Nichtlinearitäten nach Betrag und Phase weitgehend zu kompensieren.

8. Verfahren nach Anspruch 7, das ferner den Schritt des Erzeugens und/oder Aktualisierens der Korrekturwerte basierend auf der digitalen Basisbandversion (S1) des zu übertragenden Signals und einer in den Basisbandbereich heruntergemischten, analog/digital-gewandelten Version des Ausgangssignals (S5) der nichtlinearen Übertragungsstrecke aufweist.

9. Verfahren nach einem der Ansprüche 7 oder 8, das ferner den Schritt des Tiefpassfilterns der analogen Korrekturwerte vor dem Durchführen der analogen Vorverzerrung mit denselben aufweist.

10. Vorrichtung zur Vorverzerrungslinearisierung eines über eine nichtlineare Übertragungsstrecke (10) zu übertragenden Signals, mit folgenden Merkmalen:

einer Signalquelle (2) zum Bereitstellen einer digitalen Basisbandversion S1 des zu übertragenden Signals;

einer Einrichtung (12) zur Ermittlung digitaler Korrekturwerte für das zu übertragende Signal, die mit dem Ausgang der Signalquelle verbunden ist und die unter Verwendung der digitalen Basisbandversion des zu übertragenden Signals als Eingangssignal auf eine Tabelle zugreift, in der jeweiligen Eingangssignalen zugeordnete komplexe Korrekturwerte abgelegt sind, wobei die komplexen Korrekturwerte basierend auf einer vorher erfassten Übertragungsfunktion der nichtlinearen Übertragungsstrecke ermittelt wurden;

einem Digital/Analog-Wandler (4), der mit dem Ausgang der Signalquelle verbunden ist, zum Erzeugen einer analogen Version (S2) des zu übertragenden Signals aus der digitalen Basisbandversion (S1) desselben;

einem Digital/Analog-Wandler (18, 20) zum Erzeugen von analogen Korrekturwerten (a, b) aus den digitalen Korrekturwerten; **gekennzeichnet durch**

eine Einrichtung zum analogen Vorverzerren des zu übertragenden Signals **durch** Multiplikation mit den analogen Korrekturkoeffizienten (a, b) im Rahmen einer Frequenzumsetzung.

11. Verfahren zum Durchführen einer Vorverzerrungslinearisierung eines über eine nichtlineare Übertragungsstrecke (10) zu übertragenden Signals, mit folgenden Schritten:

Bereitstellen einer digitalen Basisbandversion ((S1)) des zu übertragenden Signals am Ausgang einer Signalquelle (2);

Empfangen der am Ausgang der Signalquelle bereitgestellten digitalen Basisbandversion des zu übertragenden Signals und Ermitteln digitaler Korrekturwerte für das zu übertragende Signal durch Zugreifen auf eine Tabelle unter Verwendung der digitalen Basisbandversion des zu übertragenden Signals als Eingangssignal, wobei in der Tabelle jeweiligen Eingangssignalen zugeordnete komplexe Korrekturwerte abgelegt sind, wobei die komplexen Korrekturwerte basierend auf einer vorab erfassten Übertragungscharakteristik der nichtlinearen Übertragungsstrecke (10) ermittelt wurden;

Durchführen einer Digital/Analog-Wandlung der am Ausgang der Signalquelle bereitgestellten, digitalen Basisbandversion (S1) des zu übertragenden Signals zum Erzeugen einer analogen Version (S2) des zu übertragenden Signals;

Durchführen einer Digital/Analog-Wandlung der digitalen Korrekturwerte zum Erzeugen analoger Korrekturwerte (a, b) ;

**gekennzeichnet durch** den Schritt des
Analogen Vorverzerrens des zu übertragenden Signals **durch** Multiplizieren mit den analogen komplexen Korrekturwerten (a, b) im Rahmen einer Frequenzumsetzung.

## Claims

1. Apparatus for pre-distortion linearization of a signal to be transmitted via a non-linear transmission path (10), comprising
a signal source (2) for providing a digital baseband version (S1) of the signal to be transmitted;
means (12) for determining digital correction values for the signal to be transmitted, which is connected to the output of the signal source and which, using the digital baseband version of the signal to be transmitted as input signal, accesses a table, in which complex correction values associated with respective input signals are stored, wherein the complex correction values were determined based on a previously detected transfer function of the non-linear transmission path;
a digital/analog converter (4) connected to the output of the signal source for generating an analog version (S2) of the signal to be transmitted from the digital baseband version (S1) thereof;
a digital/analog converter (18, 20) for generating analog correction values (a, b) from the digital correction values; and
an upconverter (6) for upconverting the signal to be transmitted into an intermediate frequency region or high frequency region (S3) before the pre-distorting thereof; **characterized by**
means for analog pre-distorting (8) of the signal to be transmitted by multiplying the upconverted version of the analog version (S3) of the signal to be transmitted by the analog correction values (a, b) to thereby largely compensate for non-linearities caused by the non-linear transmission path.

2. Apparatus of claim 1, further comprising means for tapping an analog output signal (S5) of the non-linear transmission path (10) and a downconverter and an analog/digital converter for converting the output signal into the baseband region and for generating a digital version thereof, wherein there is further provided means for generating and/or updating the correction values based on the digital version of the output signal (S5) and the digital baseband version (S1) of the signal to be transmitted.

3. Apparatus of one of claims 1 or 2, wherein the non-linear transmission path (10) is a power amplifier.

4. Apparatus of one of claims 1 to 3, wherein the means (8) for pre-distorting is a complex multiplier.

5. Apparatus of claim 4, wherein the complex multiplier comprises a first multiplier (28) performing a multiplication of a 90° phase-shifted version of the input signal of the complex multiplier with a first coefficient (a), and a second multiplier (30) performing a multiplication of the input signal of the complex multiplier by a second coefficient (b), wherein the first and second coefficients together represent a complex correction value.

6. Apparatus of one of claims 1 to 5, further comprising a low-pass filter (22, 24) for low-pass filtering the analog correction values.

7. Method of performing pre-distortion linearization of a signal to be transmitted via a non-linear transmission path (10), comprising:

   providing a digital baseband version (S1) of the signal to be transmitted at the output of the signal source;

   receiving the digital baseband version of the signal to be transmitted, provided at the output of the signal source, and determining digital correction values of the signal to be transmitted by accessing a table using the digital baseband version of the signal to be transmitted as input signal, wherein complex correction values associated with respective input signals are stored in the table, wherein the complex correction values were determined based on a previously detected transmission characteristic of the non-linear transmission path (10);

   performing a digital/analog conversion of the digital baseband version (S1) of the signal to be transmitted provided at the output of the signal source for generating an analog version (S2) of the signal to be transmitted;

   performing a digital/analog conversion of the digital correction values for generating analog correction values (a, b); and

   upconverting the signal to be transmitted into an intermediate frequency region or high-frequency region (S3) before or during the pre-distorting thereof; **characterized by** the step of

   analog pre-distorting the signal to be transmitted by multiplying the upconverted version of the signal to be transmitted by the analog complex correction values (a, b) to thereby largely compensate non-linearities caused by the non-linear transmission path (10) with respect to magnitude and phase.

8. Method of claim 7, further comprising the step of generating and/or updating the correction values based on the digital baseband version (S1) of the signal to be transmitted and an analog/digital-converted version of the output signal (S5) of the non-linear transmission path, down-converted into the baseband region.

9. Method of one of claims 7 or 8, further comprising the step of low-pass filtering the analog correction values before performing the analog pre-distortion therewith.

10. Apparatus for pre-distortion linearization of a signal to be transmitted via a non-linear transmission path (10), comprising:

    a signal source (2) for providing a digital baseband version (S1) of the signal to be transmitted;

    means (12) for determining digital correction values of the signal to be transmitted, which is connected to the output of the signal source and which, using the digital baseband version of the signal to be transmitted as input signal, accesses a table, in which complex correction values associated with respective input signals are stored, wherein the complex correction values were determined based on a previously detected transfer function of the non-linear transmission path;

    a digital/analog converter (4) connected to the output of the signal source for generating an analog version (S2) of the signal to be transmitted from the digital baseband version (S1) thereof;

    a digital/analog converter (18, 20) for generating analog correction values (a, b) from the digital correction values; **characterized by**

    means for analog pre-distorting the signal to be transmitted by multiplication by the analog correction coefficients (a, b) in a frequency conversion.

11. Method of performing pre-distortion linearization of a signal to be transmitted via a non-linear transmission path (10), comprising:

    providing a digital baseband version (S1) of the signal to be transmitted at the output of the signal source (2);

    receiving the digital baseband version of the signal to be transmitted, provided at the output of the signal source, and determining digital correction values for the signal to be transmitted by accessing a table using the digital baseband version of the signal to be transmitted as input signal, wherein complex correction values associated with respective input signals are stored in the table, wherein the complex correction values were determmined based on a previously detected transmission characteristic of the non-linear transmission path (10);

performing a digital/analog conversion of the digital baseband version (S1) of the signal to be transmitted, provided at the output of the signal source, for generating an analog version (S2) of the signal to be transmitted;

performing a digital/analog conversion of the digital correction values for generating analog correction values (a, b); **characterized by** the step of

analog pre-distorting of the signal to be transmitted by multiplying by the analog complex correction values (a, b) in a frequency conversion.

## Revendications

1. Dispositif de linéarisation par prédistorsion d'un signal à transmettre via un trajet de transmission non linéaire (10), aux caractéristiques suivantes :

une source de signaux (2) destinée à préparer une version de bande de base numérique (S1) du signal à transmettre ;
un dispositif (12) destiné à déterminer des valeurs de correction numériques pour le signal à transmettre qui est relié à la sortie de la source de signaux et qui, à l'aide de la version de bande de base numérique du signal à transmettre, accède à un tableau dans lequel sont mémorisées des valeurs de correction complexes associées aux signaux d'entrée respectifs, les valeurs de correction complexes ayant été déterminées sur base d'une fonction de transmission captée au préalable du trajet de transmission non-linéaire ;
un convertisseur numérique/analogique (4) qui est relié à la sortie de la source de signal, destiné à générer une version analogique (S2) du signal à transmettre à partir de la version de bande de base numérique (S1) de ce dernier ;
un convertisseur numérique/analogique (18, 20) destiné à générer des valeurs de correction analogiques (a, b) à partir des valeurs de correction numériques ; et
un transposeur de fréquence élévateur (6) destiné à transposer en fréquence vers le haut le signal à transmettre à une plage de fréquences intermédiaires ou à une plage de hautes fréquences (S3) avant la prédistorsion de ce dernier ;

**caractérisé par**

un dispositif destiné à prédistorsionner de manière analogique (8) le signal à transmettre en multipliant la version transposée en fréquence vers le haut de la version analogique (S3) du signal à transmettre par les valeurs de correction analogiques (a, b), pour compenser ainsi largement les non-linéarités provoquées par le trajet de transmission non-linéaire.

2. Dispositif selon la revendication 1, présentant, par ailleurs, un dispositif destiné à prélever un signal de sortie analogique (S5) du trajet de transmission non-linéaire (10) et un transposeur en fréquence abaisseur et un convertisseur analogique/numérique destiné à convertir le signal de sortie à la plage de bande de base et à générer une version numérique de celui-ci, par ailleurs étant prévu un dispositif destiné à générer et/ou mettre à jour les valeurs de correction sur base de la version numérique du signal de sortie (S5) et de la version de bande de base numérique (S1) du signal à transmettre.

3. Dispositif selon l'une des revendications 1 ou 2, dans lequel le trajet de transmission non linéaire (10) est un amplificateur de puissance.

4. Dispositif selon l'une des revendications 1 à 3, dans lequel le dispositif de prédistorsion est un multiplicateur complexe.

5. Dispositif selon la revendication 4, dans lequel le multiplicateur complexe présente un premier multiplicateur (28) qui effectue une multiplication de la version déphasée de 90° du signal d'entrée du multiplicateur complexe avec un premier coefficient (a), et un deuxième multiplicateur (30) qui effectue une multiplication du signal d'entrée du multiplicateur complexe avec un deuxième coefficient (b), le premier et le deuxième coefficient représentant, ensemble, une valeur de correction complexe.

6. Dispositif selon l'une des revendications 1 à 5, présentant, par ailleurs, un filtre passe-bas (22, 24) destiné à la filtration passe-bas des valeurs de correction analogiques.

7. Procédé pour effectuer une linéarisation par prédistorsion d'un signal à transmettre via un trajet de transmission non-linéaire (10), aux étapes suivantes consistant à :

préparer une version de bande de base numérique (S1) du signal à transmettre à la sortie d'une source de signal ;
recevoir la version de bande de base numérique, préparée à la sortie de la source de signal, du signal à transmettre et déterminer des valeurs de correction numériques pour le signal à transmettre en accédant à un tableau à l'aide de la version de bande de base numérique du signal à transmettre comme signal d'entrée, dans le tableau étant mémorisées des valeurs de correction complexes associées aux signaux d'entrée respectifs, les valeurs de correction complexes ayant été déterminées sur base d'une caractéristique de transmission captée au préalable du trajet de transmission non-linéaire (10) ;

effectuer une conversion numérique/analogique de la version de bande de base numérique (S1), préparée à la sortie de la source de signaux, du signal à transmettre, pour générer une version analogique (S2) du signal à transmettre ;

effectuer une conversion numérique/analogique des valeurs de correction numériques, pour générer des valeurs de correction analogiques (a, b) ; et

transposer en fréquence vers le haut le signal à transmettre à une plage de fréquences intermédiaires ou à une plage de hautes fréquences (S3), avant ou pendant la prédistorsion de ce dernier ;

**caractérisé par** l'étape consistant à :

prédistorsionner de manière analogique le signal à transmettre en multipliant la version transposée en fréquence vers le haut du signal à transmettre par les valeurs de correction complexes analogiques (a, b), afin de compenser ainsi largement en quantité et en phase les non-linéarités provoquées par le trajet de transmission non-linéaire (10).

8. Procédé selon la revendication 7, présentant, par ailleurs, l'étape consistant à générer et/ou à mettre à jour les valeurs de correction sur base de la version de bande de base numérique (S1) du signal à transmettre et d'une version convertie de manière analogique/numérique transposée en fréquence vers le bas à la plage de bande de base du signal à transmettre (S5) du trajet de transmission non-linéaire.

9. Procédé selon l'une des revendications 7 ou 8, présentant, par ailleurs, l'étape consistant à filtrer passe-bas les valeurs de correction analogiques avant d'effectuer la prédistorsion analogique par ces dernières.

10. Dispositif de linéarisation par prédistorsion d'un signal non linéaire à transmettre via un trajet de transmission (10), aux caractéristiques suivantes :

une source de signal (2) destinée à préparer une version de bande de base numérique (S1) du signal à transmettre ;

un dispositif (12) destiné à déterminer des valeurs de correction numériques pour le signal à transmettre, qui est relié à la sortie de la source de signaux et qui accède, à l'aide de la version de bande de base numérique du signal à transmettre comme signal d'entrée, à un tableau dans lequel sont mémorisées des valeurs de correction complexes associées à des signaux d'entrée respectifs, les valeurs de correction complexes ayant été déterminées sur base d'une fonction de transmission captée au préalable du trajet de transmission non-linéaire;

un convertisseur numérique/analogique (4) qui est relié à la sortie de la source de signaux, pour générer une version analogique (S2) du signal à transmettre à partir de la version de bande de base numérique (S1) de ce dernier ;

un convertisseur numérique/analogique (18, 20) destiné à générer des valeurs de correction analogiques (a, b) à partir des valeurs de correction numériques ;

**caractérisé par**

un dispositif destiné à prédistorsionner de manière analogique le signal à transmettre par multiplication par les coefficients de correction analogiques (a, b) dans le cadre d'une conversion de fréquence.

11. Procédé pour effectuer une linéarisation par prédistorsion d'un signal à transmettre via un trajet de transmission non-linéaire (10), aux étapes suivantes consistant à :

préparer une version de bande de base numérique (S1) du signal à transmettre à la sortie d'une source de signaux (2) ;

recevoir la version de bande de base numérique, préparée à la sortie de la source de signaux, du signal à transmettre et déterminer des valeurs de correction numériques pour le signal à transmettre en accédant à un tableau à l'aide de la version de bande de base numérique du signal à transmettre comme signal d'entrée, dans le tableau étant mémorisées des valeurs de correction complexes associées aux signaux d'entrée respectifs, les valeurs de correction complexes ayant été déterminées sur base d'une caractéristique de transmission captée au préalable du trajet de transmission non-linéaire (10) ;

effectuer une conversion numérique/analogique de la version de bande de base numérique (S1), préparée à la sortie de la source de signaux, du signal à transmettre, pour générer une version analogique (S2) du signal à transmettre ;
effectuer une conversion numérique/analogique des valeurs de correction numériques, pour générer des valeurs de correction analogiques (a, b) ;

**caractérisé par** l'étape consistant à :

prédistorsionner de manière analogique le signal à transmettre en multipliant par les valeurs de correction complexes analogiques (a, b) dans le cadre d'une conversion de fréquence.

Fig. 1

Fig. 2